Europäisches Patentamt

European Patent Office

Office européen des brevets

(19)

(11) EP 0 799 914 A2

## (12) EUROPEAN PATENT APPLICATION

(43) Date of publication:
08.10.1997 Bulletin 1997/41

(51) Int Cl.⁶: **C30B 33/00**, H01L 21/00

(21) Application number: 97302344.3

(22) Date of filing: 04.04.1997

(84) Designated Contracting States:
DE FR GB IT NL SE

(30) Priority: 04.04.1996 JP 82423/96

(71) Applicant: DAIDO HOXAN INC.
Sapporo-shi, Hokkaido 060 (JP)

(72) Inventors:
• Yokoyama, Takashi
Chikko Shinmachi, Sakai-shi, Osaka 592 (JP)
• Yamamoto, Kazuma
Chikko Shinmachi, Sakai-shi, Osaka 592 (JP)

• Yamamoto, Masato
Chikko Shinmachi, Sakai-shi, Osaka 592 (JP)
• Mishima, Takahiro
Chikko Shinmachi, Sakai-shi, Osaka 592 (JP)
• Matsuda, Go
Chikko Shinmachi, Sakai-shi, Osaka 592 (JP)
• Itou, Shigeki
Chikko Shinmachi, Sakai-shi, Osaka 592 (JP)

(74) Representative: Wakerley, Helen Rachael
Reddie & Grose,
16 Theobalds Road
London WC1X 8PL (GB)

### (54) A method and apparatus for producing semiconductor wafers

(57) A method for producing a wafer from a crystalline ingot comprising: supplying an etching gas, which shows a high etching property for a constituent of the crystalline ingot, in a state of a molecular beam stream onto a predetermined part of the crystalline ingot to be processed, gradually volatilizing the predetermined part from its surface so as to remove the predetermined part entirely, and finally cutting the wafer from the resulting shaped ingot. According to the method, wastes in cutting can be greatly minimized and also the work environment can be kept clean. Further, surface smoothness can be realized.

FIG. 1

Printed by Jouve, 75001 PARIS (FR)

## Description

FIELD OF THE INVENTION

The present invention relates to a method for producing a wafer and apparatus employed therein.

BACKGROUND OF THE INVENTION

A wafer employed for producing various kinds of semiconductor devices can generally be obtained by cutting out a crystalline ingot such as Si or GaAs at specific intervals so as to be formed into a plate and mirror polishing its surface. A diamond blade saw or a wire saw for metal cutting is employed for cutting a crystalline ingot heretofore. Namely, an ingot is cut out with impact caused by pressing a diamond blade rotating at a high speed or a wire vibrating at a high speed thereon.

However, there is a problem in cost effectiveness in the above cutting method because it is impossible to cut out only the part cut into by a diamond blade or a wire and also the vicinity is deformed or destroyed so that an extra space in a sizable thickness is wasted. More specifically, about 500 $\mu$m thickness is wasted to cut out a piece of wafer, which means about 50% of an ingot may be wasted when cutting out a wafer of 500 $\mu$m thickness.

In addition, as such tools are repeatedly used for cutting processes, the edge may be nicked or seizing may be caused and then the sharpness may deteriorate, so that a diamond blade, a wire or the like requires time-consuming work of periodical replacement.

Further, there is another problem that cutting fluid charged into portions to be cut, as purposes for cooling and lubrication, and debris caused in a cutting process may scatter and deteriorate the work environment. Still further, the cutting fluid including the debris is difficult to be recycled or disposed because a troublesome process, i.e., separation of the debris and the cutting fluid is indispensable.

Accordingly, the present invention can provide a superior method for producing a wafer cleanly and easily, whereby wastes can be minimized in the cutting process, and an apparatus employed therein.

The first aspect of the present invention is a method for producing a wafer from a crystalline ingot comprising: supplying an etching gas, which shows high etching property for a constituent of the crystalline ingot, in a state of a molecular beam stream onto a predetermined part of the crystalline ingot to be processed, gradually volatilizing the predetermined part from its surface so as to remove the predetermined part entirely, and finally cutting the wafer from the resulting shaped ingot.

The second aspect of the present invention is a method according to the above first aspect, in which the etching gas comprises at least one component selected from $ClF_3$, $NF_3$, $CCl_2F_2$, $CF_4$, $C_2F_6$, $C_3F_8$, $CHF_3$, $CCl_4$, $SF_6$, $CCl_3F$ and HCl.

Further, the third aspect of the present invention is a method according to the above first aspect or the second aspect, in which the etching gas is supplied onto the predetermined part of the crystalline ingot under a pressure in the range of 1 to $10^{-6}$ Torr.

Still further, the fourth aspect of the present invention is an apparatus for producing a wafer from a crystalline ingot comprising a closed chamber provided with a member for mounting the crystalline ingot and means for holding the wafer cut from the crystalline ingot, means for evacuating the chamber, and means for supplying an etching gas, which shows a high etching property for a constituent of the crystalline ingot, in a state of a molecular beam stream onto a predetermined part of the crystalline ingot to be processed, which is mounted on the member for mounting the crystalline ingot.

Even still further, the fifth aspect of the present invention is an apparatus according to the above fourth aspect in which the crystalline ingot is prismatic, an injector having a plurality of slits formed in parallel is provided toward a side of the prismatic ingot, the etching gas is injected from each of the slits simultaneously so as to cut a plurality of wafers simultaneously.

A constituent (for example, silicon atoms) of a crystalline ingot causes a chemical reaction by colliding with etching gas atoms or molecules a number of times and separates from the ingot surface. In the present invention, "an etching gas which shows a high etching property" means an etching gas showing a property that the number of such collisions of the etching gas atoms or molecules with the constituent of the crystalline ingot needed to separate the constituent of the crystalline ingot is relatively few, specifically less than or equal to 10 times. On the other hand, a usual etching gas ($BCl_3$, $SiCl_4$, $Br_2$ or the like) requires several tens to 100 collisions to cause the separation. There is a big difference in the property between conventional etching gases and the gases used in the present invention.

SUMMARY OF THE INVENTION

The present invention will be now described in detail.

First, as a crystalline ingot in the present invention, there are various kinds of crystalline ingots heretofore employed as wafer materials. For example, there are crystalline ingots formed by a monocrystal or a polycrystal of Si, GaAs, $SiO_2$, $Si_3N_4$, $Al_2O_3$, or the like. Although the shapes of the crystalline ingots are not limited specifically, they are normally cylindrical or prismatic.

As an etching gas for cutting the crystalline ingot, it is required to use the gas showing a high etching property for the constituent of the crystalline ingot (just referred to as "the high etching gas" hereinafter). Suitable high etching gas, as mentioned above, are those etching gases with a probability of not less than 10% by colliding with the constituent of the crystalline ingot, for example, $ClF_3$, $NF_3$, $CCl_2F_2$, $CF_4$, $C_2F_6$, $C_3F_8$, $CHF_3$, $CCl_4$, $SF_6$, $CCl_3F$, HCl and the like. However, the etching property of these gases depends on the material of the ingot as an object to be etched. These gases may not necessarily show a high etching property on every ingot. These gases are employed solely or in combination of two or more. In addition, the etching speed of the above $ClF_3$ on silicon atoms is approximately 50 µm per minute at atmospheric pressure and 100°C which is very fast. The probability of the etching of $ClF_3$ can be obtained from the above etching speed and the calculated number of collisions between $ClF_3$ gas molecules and silicon atoms, and is approximately 1/2, which is very high.

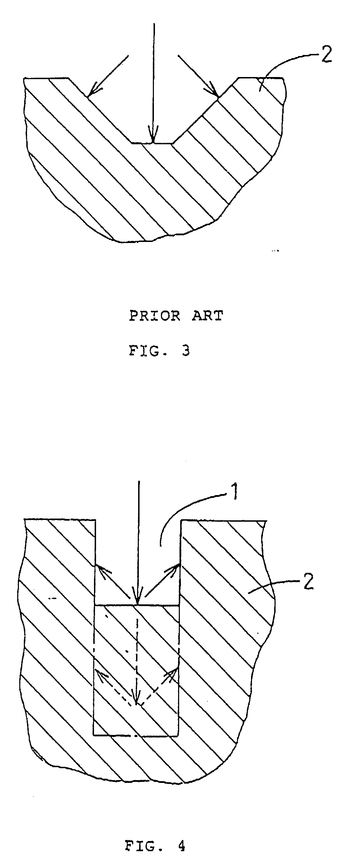

However, the spread of the etching cut into the crystalline ingot cannot be minimized if the above high etching gas is employed as it is. Namely, if the high etching gas is employed for etching as it is, the gas molecules collide with the ingot surface at random, so that the etching simultaneously spreads widthwise as well as down into the surface of the ingot, as shown in Fig. 3. As a result, not only the part as the desired object but also its vicinity as an extra space is etched. This is called "under etching" and is not desired.

The high etching gas is supplied to the crystalline ingot in a state of a molecular beam stream wherein the mean free path of the gas molecules becomes large so that under etching is minimized and wafers can be cut out effectively. To obtain the molecular beam stream, it is preferable to conduct the supply of the high etching gas under a pressurized environment of a vacuum of 1 to $10^{-6}$ Torr.

As mentioned above, when the high etching gas is supplied to the crystalline ingot in the state of a molecular beam stream, the gas molecules collide with the surface of the ingot 2 linearly as shown in Fig. 4 in such a manner that a groove 1 is formed on the surface by etching at a high probability, for example, 1/2. In the meantime, another 1/2 of the remaining non-reacted gas reacts with the side wall of the groove 1 at a probability of 1/2, which means etching of a 1/4 probability [ $(1/2) \times (1/2) = 1/4$] of the total, which is not so much. Furthermore, the degree of etching in the side wall is low and hardly causes any problem, because the position where the gas molecules rebound against the side wall slides more downward as the depth of the groove becomes deeper by etching. As a result, etching can be conducted deeply within a limited area, without wide-range under etching, as shown in Fig. 3.

BRIEF DESCRIPTION OF THE DRAWINGS

The invention will be more fully described, taken with the appended drawings, in which:

Fig. 1 is a schematic view of an apparatus of one embodiment according to the present invention;
Fig. 2 is a view in the direction of the arrow A-A' in Fig. 1;
Fig. 3 is an explanatory view of a normal etching mode; and
Fig. 4 is an explanatory view of an etching mode according to the present invention.

DESCRIPTION OF THE PREFERRED EMBODIMENTS

The following is the detailed description of the embodiment of the present invention.

EXAMPLE

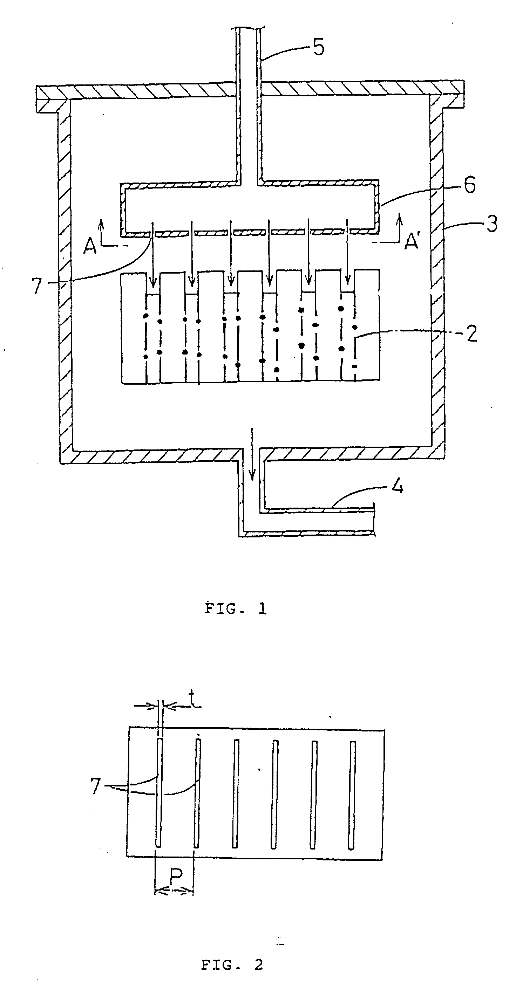

Fig. 1 illustrates one embodiment of an apparatus used in a method for obtaining a wafer from a prismatic crystalline ingot 2 according to the present invention. In this apparatus, 3 is a closed chamber in which the prismatic crystalline ingot 2 (just abbreviated to "ingot" hereinafter) can be sustained, laid on its side on means for mounting an ingot (not shown). The apparatus is further provided with means for holding wafers (not shown) cut out of the ingot 2 and means for taking the wafers (not shown) to the outside of the chamber 3.

An exhaust tube 4 for evacuating the chamber 3 is connected to the bottom of the chamber 3, whereby the degree of vacuum in the chamber 3 can be established appropriately.

In the meantime, an inlet tube 5 for introducing a high etching gas to cut the ingot 2 extends into the chamber 3 from outside through the ceiling of the chamber. An injector 6 is provided at the end of the inlet pipe 5 so that the high etching gas is injected toward the upper surface of the ingot 2 (or toward one side in case of a prismatic ingot).

In addition, the outlets of the injector 6 are formed by a plurality of slits 7 positioned in parallel at equal intervals as shown in Fig.2, a view in the direction of the arrow A-A' in Fig. 1. The width "t" of the slit 7 is normally set within a range of 10 to 100 µm. The interval "P" between the slits 7 is set at a size of a suitable thickness of a wafer as an object plus α (for an extra space) and usually set within a range of 200 to 500 µm.

With employing the above apparatus, wafers can be cut out, for example, as follows. Namely, first a prismatic ingot 2 made of Si monocrystal is mounted in the chamber 3. The chamber is then evacuated from the exhaust tube 4 so as to be at the order of 1 to $10^{-6}$ Torr. Then, $ClF_3$ gas is introduced therein through the inlet tube 5 as the high etching gas.

The $ClF_3$ gas is injected toward the upper surface of the ingot 2 from each slit 7 of the injector 6 as shown in arrows in Fig. 1. At that time, the injection stream of the $ClF_3$ gas is supplied on the upper surface of the ingot 2 in a state of a molecular beam stream since the chamber 3 is set at a high vacuum. For this reason, the $ClF_3$ gas goes straight without diffusion and collides with a limited zone corresponding to each slit 7. In the zone, Si as a constituent of the ingot 2 and the $ClF_3$ gas are reacted as follows so that the upper surface of the ingot 2 can be etched so as to be shaped into grooves (as shown in Fig. 4).

$$4ClF_3 + 3Si \rightarrow 3SiF_4 \text{ (volatile matter)} + 2Cl_2 \text{ (gas)}$$

Therefore, grooves in approximately the same width of the slit 7 are formed at the same intervals as those of the slits 7 and gradually shaved deeply by degrees so that the predetermined part to be cut can be etched finally as shown as chain lines in Fig. 1 whereby a plurality of wafers can be cut simultaneously. Thus obtained wafers are taken out of the chamber 3.

In this way, because the high etching gas ($ClF_3$) is supplied in a state of a molecular beam stream from each slit 7 of the injector 6 over the upper surface of the ingot 2 the predetermined parts can be volatilized and removed in the specifically determined sizes according to the above apparatus, and thus unneeded extra ingot over and above the desired size can be greatly decreased compared with the prior methods, resulting in minimizing waste of the ingot in cutting. Further, smoothness on the cut surface is excellent. Still further, the work environment is clean because cutting fluid or debris is not scattered, which is different from the prior methods. Furthermore, the present invention realizes good workability without tool replacement.

In addition, a plurality of slits 7 is provided in the injector 6 in the above EXAMPLE in such a manner that a plurality of wafers is cut simultaneously. However, only one slit at the end of the injector 6 is acceptable, whereby one spot of the ingot 2 can be cut. In this case, the above cutting process is conducted from one end of the ingot 2 and then the injector 6 and/or the ingot 2 are/is correlatively slid by one thickness of a piece of wafer every time a cutting process of one piece has been completed, whereby wafers can be consecutively cut.

Further, a prismatic ingot was employed as the ingot 2 in the EXAMPLE. However, the shape of the ingot 2 is not limited thereto and a cylindrical one is also acceptable.

EFFECTS OF THE INVENTION

As mentioned above, the present invention relates to a method in which a high etching gas is supplied in a state of a molecular beam stream onto the ingot surface so that a gas constituent of the high etching gas and a constituent of the ingot are chemically reacted whereby the predetermined part on the surface of the ingot is volatilized and removed. Wafers have heretofore been cut from an ingot by a physical cutting method. Because the high etching gas is supplied over the upper surface of the ingot 2 in the limited width so that the predetermined parts can be volatilized and removed in the limited width according to the method of the present invention, any extra unwanted removed parts of the ingot are greatly decreased compared with the prior methods, resulting in minimizing wastes in cutting. Further, the work environment is clean because cutting fluid or debris is not scattered, which is different from the prior methods.

Furthermore, the present invention realizes good workability without tool replacement.

Still further, because the thus obtained wafer is excellent in its surface smoothness unlike the prior cutting methods, surface polishing is unnecessary or can be shortened, if any, according to the present invention. Even still furthermore, the above method can be performed effectively by using the apparatus of the present invention.

**Claims**

1. A method for producing a wafer from a crystalline ingot comprising: supplying an etching gas, which shows a high etching property for a constituent of the crystalline ingot, in a state of a molecular beam stream onto a predetermined part of the crystalline ingot to be processed, gradually volatilizing the predetermined part from its surface so as to remove the predetermined part entirely, and finally cutting the wafer from the resulting shaped ingot.

2. A method according to claim 1, in which the etching gas comprises at least one component selected from $ClF_3$, $NF_3$, $CCl_2F_2$, $CF_4$, $C_2F_6$, $C_3F_8$, $CHF_3$, $CCl_4$, $SF_6$, $CCl_3F$ and $HCl$.

3. A method according to claim 1 or 2, in which the etching gas is supplied onto the predetermined part of the crystalline ingot under a pressure in the range 1 to $10^{-6}$ Torr.

4. An apparatus for producing a wafer from a crystalline ingot comprising a closed chamber provided with a member for mounting the crystalline ingot and means for holding the wafer cut from the crystalline ingot, means for evacuating the chamber, and means for supplying an etching gas, which shows a high etching property for a constituent of the crystalline ingot, in a state of a molecular beam stream onto a predetermined part of the crystalline ingot to be processed, which is mounted on the member for mounting the crystalline ingot.

5. An apparatus according to claim 4 in which the crystalline ingot is prismatic, an injector having a plurality of slits formed in parallel is provided toward a side of the prismatic ingot, the etching gas is injected from each of the slits simultaneously so as to cut a plurality of wafers simultaneously.

FIG. 1

FIG. 2

PRIOR ART

FIG. 3

FIG. 4